# DEMANDE DE BREVET EUROPEEN

(11) **EP 1 113 579 A1**
(43) Date de publication de la demande: **04.07.2001**
(21) Numéro de dépôt: 00204624.1
(22) Date de dépôt: 19.12.2000
(51) Int. Cl.: H03K 23/66

(54) **Procédé pour diviser la fréquence d'un signal**

(30) Priorité: 29.12.1999 FR 9916675
(71) Demandeur: Koninklijke Philips Electronics N.V., 5621 BA Eindhoven (NL)
(72) Inventeur: Flecheux, Bertrand, 75008 Paris (FR)
(74) Mandataire: Chaffraix, Jean

(57) **Abrégé**

La présente invention concerne un procédé pour diviser la fréquence d'un signal électronique X0 incluant les étapes suivantes :
. pré-chargement d'une première valeur prédéterminée P(1:N) dans un compteur/décompteur L1...LN,
. cadencement du compteur/décompteur L1...LN au moyen dudit signal électronique X0,
. détection d'un état dans lequel le compteur/décompteur présente une deuxième valeur prédéterminée, et
. nouveau pré-chargement de la première valeur prédéterminée P(1:N) dans le compteur/décompteur L1...LN.

Selon l'invention, les pré-chargements sont faits de manière asynchrone.

L'invention permet de réduire le bruit introduit dans la tension d'alimentation d'un diviseur de fréquence DIV par les pré-chargements périodiques du compteur/décompteur L1...LN qu'il contient.
- Application:: Boucles à verrouillage de phase pour radiotéléphones ou télévisueurs,
- Référence:: Figure 2.

## Description

La présente invention concerne un procédé pour diviser la fréquence d'un signal électronique incluant les étapes suivantes :
. pré-chargement d'une première valeur prédéterminée dans un compteur/décompteur,
. cadencement du compteur/décompteur au moyen dudit signal électronique,
. détection d'un état dans lequel le compteur/décompteur présente une deuxième valeur prédéterminée, et
. nouveau pré-chargement de la première valeur prédéterminée dans le compteur/décompteur.

De tels procédés sont couramment utilisés dans de multiples applications, par exemple dans des boucles à verrouillage de phase destinées à réguler la fréquence d'un oscillateur. Ces boucles à verrouillage de phase comportent usuellement :
. un premier oscillateur local destiné à délivrer un signal de sortie ayant une fréquence d'oscillation déterminée par la valeur d'une tension de réglage,
. un deuxième oscillateur local destiné à délivrer, via un diviseur de fréquence présentant un rapport de division programmable, un signal de référence ayant une fréquence de référence,
. un détecteur de phase/fréquence destiné à comparer la fréquence d'oscillation avec la fréquence de référence et à délivrer des signaux de commande représentatifs du résultat de ladite comparaison, et
. une pompe de charge dont la conduction est destinée à être contrôlée par les signaux de commande, une sortie de la pompe de charge étant reliée à une capacité destinée à générer à ses bornes la tension de réglage.
Dans une telle boucle à verrouillage de phase, le procédé décrit dans le paragraphe introductif est mis en oeuvre au sein du diviseur de fréquence, dont le rapport de division est déterminé par la différence entre les première et deuxième valeurs prédéterminées. Le diviseur de fréquence inclut en principe N bascules mémoire disposées en cascade, chacune pouvant être pré-chargée par un bit d'un signal de sélection qui définit une des valeurs prédéterminées.

Dans les procédés de division de fréquence connus, les pré-chargements sont effectués de manière synchrone, c'est à dire que toutes les bascules mémoire sont pré-chargées simultanément dès qu'une autorisation de pré-chargement a été reçue par le diviseur de fréquence. Chaque bascule mémoire étant alimentée en énergie au moyen d'une borne positive et d'une borne négative d'alimentation, le changement d'état d'une bascule mémoire provoque un appel de courant depuis la borne positive d'alimentation. Le diviseur de fréquence est le plus souvent réalisé sous forme intégrée au sein d'un circuit intégré présentant des broches d'alimentation auxquelles les bornes d'alimentation sont reliées par des fils conducteurs, qui ont un caractère inductif. La demanderesse a constaté que les pré-chargements causaient des perturbations dans le fonctionnement du diviseur de fréquence et dans celui d'autres éléments avec lesquels le diviseur de fréquence partage son alimentation en énergie. Il a été en effet observé qu'un changement d'états simultané d'un grand nombre de bascules mémoire, qui se produit de façon périodique, provoque des variations périodiques des potentiels des bornes d'alimentation, du fait du caractère inductif des fils conducteurs reliant les broches d'alimentation aux bornes d'alimentation, variations qui génèrent un bruit dans tous les signaux électroniques présents dans les éléments alimentés au moyen desdites bornes d'alimentation.

La présente invention a pour but de remédier dans une large mesure à cet inconvénient en proposant un procédé pour diviser la fréquence d'un signal électronique qui met en oeuvre des pré-chargements périodiques sans pour autant perturber de manière significative les potentiels des bornes d'alimentation.

En effet, un procédé conforme au paragraphe introductif est caractérisé selon l'invention en ce que les pré-chargements sont faits de manière asynchrone.

Conformément à ce procédé, il ne se produit plus de situations dans lesquelles un grand nombre de bascules mémoire changent d'état simultanément, ce qui évite que les forts appels de courant périodiques décrits plus haut ne se produisent et ne perturbent les potentiels des bornes d'alimentation.

Dans un mode de mise en oeuvre particulier de l'invention, le compteur/décompteur étant constitué de N bascules mémoire disposées en cascade, chacune destinée à être pré-chargée périodiquement, une bascule de rang i (pour i=2 à N) n'est pré-chargée qu'à la condition que la bascule de rang (i-1) ait été précédemment pré-chargée.

Dans ce mode de mise en oeuvre, les bascules mémoire sont pré-chargées les unes après les autres. La consommation de courant nécessaire à un pré-chargement est donc répartie dans le temps, ce qui limite considérablement l'amplitude de la variation de potentiel des bornes d'alimentation due à cette consommation de courant.

Comme on l'a vu précédemment l'invention concerne également, dans un de ses modes de réalisation, un diviseur de fréquence incluant N bascules mémoire, chacune munie d'une entrée d'horloge, d'une entrée d'autorisation de pré-chargement, et d'une sortie, la sortie d'une bascule de rang i (pour i=1 à N-1) étant reliée à l'entrée d'horloge de la bascule de rang (i+1), l'entrée d'horloge de la bascule mémoire de rang 1 étant destinée à recevoir un signal d'entrée du diviseur, la sortie de la bascule mémoire de rang N étant destinée à délivrer un signal de sortie du diviseur,
diviseur de fréquence caractérisé en ce qu'il est muni de moyens d'inhibition prohibant un pré-chargement simultané de toutes les bascules mémoire.

Les moyens d'inhibition comprendront avantageusement des moyens de retardement agencés de sorte qu'une bascule de rang i (pour i=2 à N) ne puisse recevoir d'autorisation de pré-chargement qu'à la condition que la bascule de rang (i-1) ait été précédemment pré-chargée.

Dans un mode de réalisation préféré de l'invention, les entrées d'autorisation de pré-chargement de deux bascules mémoire de rangs consécutifs sont reliées entre elles via une cellule à retard.

Cette structure permet d'assurer de manière simple et peu coûteuse que les bascules mémoire seront pré-chargées les unes après les autres, et non simultanément, comme c'est le cas dans les diviseurs de fréquence connus.

Si la présente invention peut être utilisée dans tous types d'applications faisant appel à une division de fréquence, sa mise en oeuvre est particulièrement avantageuse dans un appareil récepteur de signaux radioélectriques, comme un radiotéléphone ou un téléviseur, comportant un étage d'entrée permettant la réception d'un signal dont la fréquence est sélectionnée au sein d'une gamme de fréquences donnée, et sa transformation en un signal électronique dit signal radio, appareil dans lequel une conversion de fréquence, à partir de la fréquence sélectionnée vers une fréquence intermédiaire prédéterminée, est réalisée au moyen d'un mélangeur destiné à recevoir le signal radio, d'une part, et le signal de sortie d'un premier oscillateur local,
appareil caractérisé en ce que la fréquence du signal de sortie du premier oscillateur local est régulée au moyen d'un boucle de verrouillage de phase incluant un diviseur de fréquence tel que décrit plus haut.

L'invention sera mieux comprise à l'aide de la description suivante, faite à titre d'exemple non-limitatif et en regard des dessins annexés, dans lesquels :
- la figure 1 est un schéma fonctionnel partiel décrivant un appareil récepteur de signaux radioélectriques incluant un diviseur de fréquence mettant en oeuvre l'invention,
- la figure 2 est un schéma fonctionnel décrivant partiellement un tel diviseur de fréquence, et
- la figure 3 est un schéma électrique décrivant une bascule mémoire incluse dans un diviseur de fréquence conforme à un mode de réalisation préféré de l'invention.

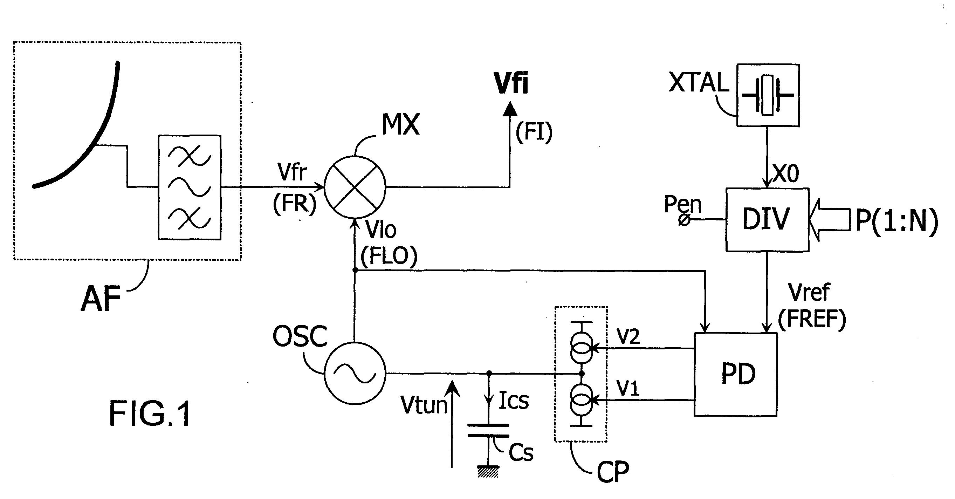

La figure 1 représente schématiquement un appareil récepteur de signaux radioélectriques, par exemple un radiotéléphone. comportant un étage d'entrée, matérialisé ici par un système d'antenne et de filtrage AF, permettant la réception d'un signal dont la fréquence est sélectionnée au sein d'une gamme de fréquences donnée, et sa transformation en un signal électronique Vfr dit signal radio, appareil dans lequel une conversion de fréquence, à partir d'une fréquence radio FR sélectionnée vers une fréquence intermédiaire FI prédéterminée, est réalisée au moyen d'un mélangeur MX destiné à recevoir le signal radio Vfr, d'une part, et un signal de sortie Vlo d'un premier oscillateur local OSC ayant une fréquence d'oscillation FLO.
La fréquence intermédiaire FI est fixée et est égale à la différence entre la fréquence radio FR et la fréquence d'oscillation FLO. Le choix de ladite fréquence d'oscillation FLO détermine donc la valeur de la fréquence radio FR sélectionnée.
Dans cet appareil, la fréquence d'oscillation FLO est régulée au moyen d'un boucle de verrouillage de phase, qui comporte :
. le premier oscillateur local OSC destiné à délivrer le signal de sortie Vlo dont la fréquence d'oscillation FLO est déterminée par la valeur d'une tension de réglage Vtun,
. un deuxième oscillateur local XTAL destiné à délivrer, via un diviseur de fréquence DIV présentant un rapport de division programmable, un signal de référence Vref ayant une fréquence de référence FREF,
. un détecteur de phase/fréquence PD destiné à comparer la fréquence d'oscillation FLO avec la fréquence de référence FREF et à délivrer des signaux de commande V1 et V2 représentatifs du résultat de ladite comparaison,
. une pompe de charge CP dont la conduction est destinée à être contrôlée par les signaux de commande V1 et V2, une sortie de la pompe de charge étant reliée à une capacité Cs destinée à générer à ses bornes la tension de réglage Vtun.

La programmation du rapport de division du diviseur de fréquence DIV se fait par un choix de la valeur d'un signal de sélection P(1:N) destiné à être périodiquement pré-chargé dans N bascules mémoire formant un compteur/décompteur contenu dans le diviseur de fréquence DIV. Ce pré-chargement est opéré quand une entrée d'autorisation de pré-chargement du diviseur de fréquence DIV reçoit un signal d'autorisation de pré-chargement Pen actif, par exemple à un niveau logique 1. Le compteur/décompteur ayant été pré-chargé à la première valeur prédéterminée qui est celle du signal de sélection P(1:N), il est ensuite cadencé par un signal de sortie X0 du deuxième oscillateur local XTAL, qui sera par exemple un oscillateur à quartz.

Dans le cas où le compteur/décompteur fonctionne en mode compteur, il délivrera un front actif, par exemple un front montant, lorsqu'il aura compté jusqu'à la deuxième valeur prédéterminée.

Dans le cas où le compteur/décompteur fonctionne en mode décompteur, la première valeur prédéterminée sera différente de zéro, et le décompteur délivrera un front inactif, par exemple un front descendant, lorsqu'il aura décompté jusqu'à la deuxième valeur prédéterminée qui sera avantageusement la valeur zéro.

Dans les deux cas précédents, le choix de la valeur du signal de sélection détermine le rapport de la division de fréquence effectuée par le diviseur DIV.

Si la fréquence d'oscillation FLO est supérieure à la fréquence de référence FREF, le détecteur de phase PD place à l'état actif un premier signal de commande V1, qui ordonne à la pompe de charge CP de délivrer un courant Ics positif. Ce courant, transmis à la capacité Cs, provoque un accroissement de la valeur de la tension de réglage Vtun prélevée aux bornes de la capacité Cs, et donc un accroissement de la fréquence d'oscillation FLO.

Lorsque la fréquence d'oscillation FLO devient inférieure à la fréquence de référence FREF, le détecteur de phase PD place à l'état actif un deuxième signal de commande V2, complémentaire du premier signal de commande V1, ce qui provoque une inversion du sens du courant Ics, qui devient négatif. Ce courant négatif, transmis à la capacité Cs, provoque une diminution de la valeur de la tension de réglage Vtun prélevée aux bornes de la capacité Cs, et donc une diminution de la fréquence d'oscillation FLO. La boucle à verrouillage de phase tendra vers un régime d'équilibre, encore appelé régime de verrouillage, dans lequel FLO=FREF.
Si la figure 1 ne représente que la partie réceptrice de l'appareil, il est à noter que, dans le cas où l'appareil comporte en outre une partie émettrice, comme c'est le cas pour un radiotéléphone, ladite partie émettrice réalisera également une conversion de fréquence, depuis la fréquence intermédiaire vers une fréquence d'émission, laquelle conversion de fréquence pouvant aussi être opérée au moyen d'une boucle à verrouillage de phase contenant un diviseur de fréquence dans lequel l'invention est mise en oeuvre. Par ailleurs, dans certaines applications, le signal de sortie du mélangeur MX pourra être démodulé au moyen d'une autre boucle à verrouillage de phase conforme à l'invention.

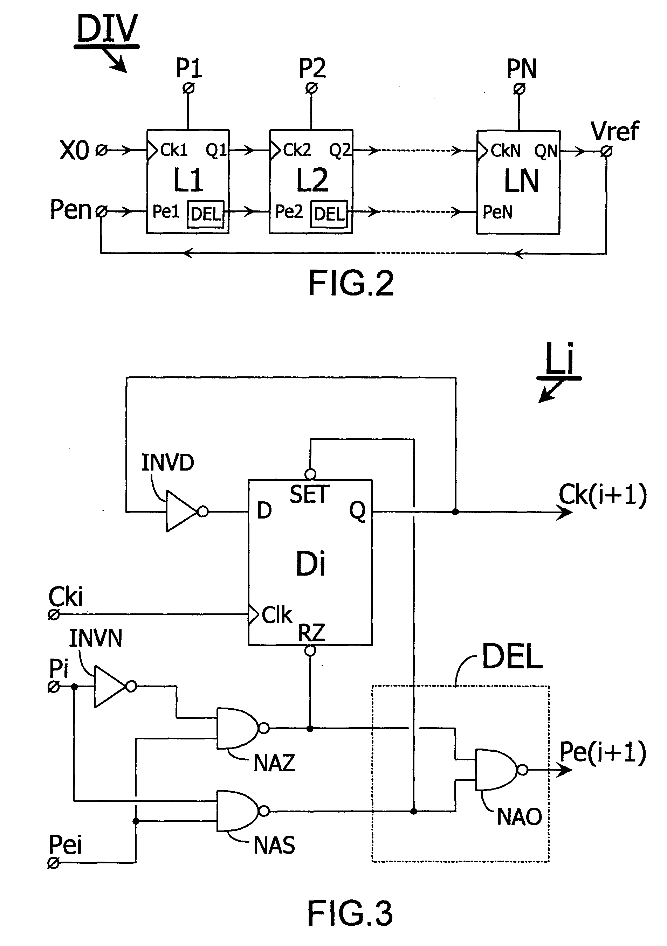

La figure 2 est un schéma fonctionnel qui représente partiellement un diviseur de fréquence DIV selon un mode de mise en oeuvre de l'invention. Ce diviseur de fréquence comporte N bascules mémoire Li (pour i=1 à N), chacune munie d'une entrée d'horloge Cki, d'une entrée d'autorisation de pré-chargement Pei, et d'une sortie Qi. Lorsqu'une bascule Li (pour i=1 à N) reçoit sur son entrée d'autorisation de pré-chargement Pei un signal actif, par exemple un niveau logique 1, un bit Pi est pré-chargé dans ladite bascule Li, c'est-à-dire que sa sortie Qi recopie la valeur du bit Pi. Dans cet exemple les bits Pi forment ensemble le signal de sélection P(1:N). La sortie Qi d'une bascule de rang i (pour i=1 à N-1) est reliée à l'entrée d'horloge Ck(i+1) de la bascule de rang (i+1). L'entrée d'horloge Ck1 de la bascule mémoire de rang 1 L1 est destinée à recevoir le signal d'entrée du diviseur DIV, constitué dans cet exemple par le signal de sortie X0 du deuxième oscillateur local XTAL. La sortie de la bascule mémoire de rang N LN est destinée à délivrer le signal de sortie du diviseur DIV, formant ici le signal de référence Vref.
Ce diviseur de fréquence DIV est muni de moyens d'inhibition prohibant un pré-chargement simultané de toutes les bascules mémoire. En effet, les entrées d'autorisation de pré-chargement Pei sont cascadées, et donc reliées en série plutôt qu'en parallèle comme c'est le cas dans les diviseurs de fréquence connus.
Dans le mode de réalisation du diviseur DIV décrit par cette figure, les moyens d'inhibition comprennent des moyens de retardement DEL agencés de sorte qu'une bascule de rang i LI (pour i=2 à N) ne puisse recevoir d'autorisation de pré-chargement qu'à la condition que la bascule de rang (i-1) L(i-1) ait été précédemment pré-chargée.
Dans ce mode de mise en oeuvre, les bascules mémoire Li sont pré-chargées les unes après les autres. La consommation de courant nécessaire à un pré-chargement des N bascules mémoire L1...LN est donc répartie dans le temps, ce qui limite considérablement l'amplitude de la variation de potentiel des bornes d'alimentation due à cette consommation de courant. En effet, cette variation est liée à une différence de potentiel générée par un fil conducteur reliant une borne d'alimentation du circuit intégré contenant le diviseur de fréquence et une broche reliant le circuit intégré à l'extérieur. Le fil conducteur présentant un caractère inductif, la différence de potentiel qu'il génère s'exprime sous la forme L.di/dt, où L est l'inductance du fil conducteur, di est la variation du courant traversant ledit fil, et dt l'intervalle de temps au cours duquel ladite variation se produit. A di constant, plus dt sera grand, plus l'amplitude de la variation de potentiel de la borne d'alimentation occasionnée par la variation de courant di traversant le fil conducteur sera faible.
Dans l'exemple décrit ici, le compteur/décompteur fonctionne en mode compteur : si la première valeur prédéterminée est la valeur zéro, soit Pi=0 (pour i=1 à N), il faudra 2^{N} fronts actifs de X0 pour provoquer l'apparition d'un front montant de Vref, ce qui signifie que le rapport de la division de fréquence opérée par le diviseur DIV est alors égal à 2^{N}.
La sortie QN de la bascule de rang N LN a été reliée à l'entrée d'autorisation de pré-chargement Pe1 de la bascule de rang 1 L1. Il s'agit là d'un moyen très simple d'assurer un pré-chargement périodique de la première valeur prédéterminée dans le compteur/décompteur constitué par les N bascules mémoires L1...LN. Dans d'autres modes de réalisation, on pourra générer le signal d'autorisation de pré-chargement de la première bascule L1 différemment. Ainsi, si le compteur/décompteur fonctionne en mode décompteur, un inverseur sera inséré entre la sortie QN de la bascule mémoire de rang N LN et l'entrée d'autorisation de pré-chargement Pe1 de la bascule mémoire de rang 1 L1, à moins que la bascule de rang N ne dispose d'une sortie inverseuse, qui sera alors directement reliée à l'entrée d'autorisation de pré-chargement Pe1. Dans ces deux cas, on veillera à ce que le Nème bit PN du signal de sélection P(1:N) soit toujours au niveau logique 1.

La figure 3 est un schéma électrique qui représente un mode de réalisation de l'une des bascules mémoire Li (pour i=1 à N) contenues dans un diviseur de fréquence conforme à l'invention. Cette bascule mémoire Li contient une bascule D Di munie d'une entrée de données D, d'une sortie de données Q, d'une entrée d'horloge Clk, d'une entrée de remise à zéro RZ, et d'une entrée de remise à un SET. La sortie de données Q est reliée à l'entrée de données D via un inverseur INVD, et est destinée à être reliée à l'entrée d'horloge Ck(i+1) de la bascule mémoire de rang suivant L(i+1). L'entrée d'horloge Clk de la bascule D Di forme l'entrée d'horloge Cki de la bascule mémoire Li.
Dans l'exemple décrit ici, lorsque la bascule D Di reçoit sur son entrée de remise à un SET un état inactif, par exemple un niveau logique 0, la sortie de données Q est immédiatement placée à l'état actif, c'est-à-dire au niveau logique 1. Lorsque la bascule D Di reçoit sur son entrée de remise à zéro RZ un état inactif, c'est-à-dire un niveau logique 0, la sortie de données Q est immédiatement placée à l'état inactif, c'est-à-dire au niveau logique 0.
La bascule mémoire Li est en outre munie d'une entrée de pré-chargement Pi, destinée à recevoir le bit de rang i du signal de sélection P(1:N), et d'une entrée d'autorisation de pré-chargement Pei.
La bascule mémoire Li contient une première porte NON-ET NAZ, munie d'une entrée reliée à l'entrée de pré-chargement Pi via un inverseur INVN, d'une autre entrée reliée à l'entrée d'autorisation de pré-chargement Pei, et d'une sortie reliée à l'entrée de remise à zéro RZ de la bascule D Di. La bascule mémoire Li contient une deuxième porte NON-ET NAS, munie d'une entrée reliée directement à l'entrée de pré-chargement Pi, d'une autre entrée reliée à l'entrée d'autorisation de pré-chargement Pei, et d'une sortie reliée à l'entrée de remise à un SET de la bascule D Di. La bascule mémoire Li contient une troisième porte NON-ET NAO, munie de deux entrées reliées aux sorties des première et deuxième portes NON-ET NAZ et NAS, et d'une sortie destinée à être reliée à l'entrée d'autorisation de pré-chargement Pe(i+1) de la bascule mémoire de rang suivant L(i+1).
En régime de fonctionnement normal, l'entrée d'autorisation de pré-chargement Pei de la bascule mémoire Li est dans un état inactif, c'est-à-dire dans cet exemple au niveau logique 0, ce qui impose un niveau logique 1 en sortie des première et deuxième portes NON-ET NAZ et NAS, et inhibe donc le pré-chargement de la bascule D Di, tandis que la sortie de la troisième porte logique NAO est, elle, maintenue au niveau logique 0, ce qui assure une inhibition du pré-chargement de la bascule mémoire de rang suivant L(i+1). La bascule D Di opère alors une division par deux de la fréquence du signal reçu sur son entrée d'horloge Clk. En effet, si à un instant t0, la sortie de données Q de la bascule D Di est au niveau logique 0, son entrée de données D est au niveau logique 1. Lorsque l'entrée d'horloge Clk reçoit un front actif, en l'occurrence un front montant, la sortie de données Q bascule vers le niveau logique 1, cette information se traduisant après son transit au travers l'inverseur INVD par une mise au niveau logique zéro de l'entrée de données D. Au front actif suivant reçu par l'entrée d'horloge Clk, la sortie de données Q retrouve le niveau logique 0, et il faudra encore un front montant à l'entrée d'horloge Clk pour produire un nouveau front montant à la sortie de données Q. Il faut ainsi fournir à l'entrée d'horloge de la bascule D Di deux fronts montants pour qu'elle produise un front montant sur sa sortie de données Q.
Lorsque la bascule mémoire Li reçoit sur son entrée d'autorisation de pré-chargement Pei un niveau actif, c'est-à-dire dans cet exemple un niveau logique 1, le pré-chargement de la bascule D Di n'est plus inhibé. Si le bit de rang i du signal de sélection P(1:N) est au niveau logique 0, la sortie de l'inverseur INVN et au niveau logique 1, et la sortie de la première porte NON-ET NAZ passe au niveau logique 0, ordonnant ainsi une remise à zéro immédiate de la sortie de données Q de la bascule D Di. Si le bit de rang i du signal de sélection P(1:N) est au niveau logique 1, la sortie de l'inverseur INVN est au niveau logique 0, et la sortie de la deuxième porte NON-ET NAS passe au niveau logique 0, ordonnant ainsi une remise à un immédiate de la sortie de données Q de la bascule D Di. Le bit de rang i du signal de sélection P(1:N) est ainsi pré-chargé dans la bascule mémoire Li.
Ce n'est que lorsque la sortie de l'une des première ou deuxième portes NON-ET NAZ ou NAS est passée au niveau logique 0, et donc lorsque le pré-chargement de la bascule mémoire Li a été effectué, que la sortie de la troisième porte NON-ET NAO peut passer du niveau logique 0 au niveau logique 1. Un tel basculement n'est pas instantané, mais intervient après un temps de transit intrinsèque à la porte logique NAO, qui est de l'ordre de la nanoseconde. La porte NAO constitue donc une cellule à retard DEL, insérée entre les entrées d'autorisation de pré-chargement de deux bascules mémoire consécutives Li et L(i+1), qui assure que les bascules mémoire constituant le diviseur de fréquence ne sont pas pré-chargées simultanément, mais les unes après les autres.

Si, dans les exemples décrits ici, les états actifs et inactifs correspondent aux niveaux logiques 1 et 0, respectivement, l'inverse est bien évidemment envisageable. Ceci impliquera alors des adaptations mineures des structures décrites plus haut, qui peuvent être déduites des théorèmes de Morgan par l'homme du métier.

## Revendications

1. Procédé pour diviser la fréquence d'un signal électronique incluant les étapes suivantes :
. pré-chargement d'une première valeur prédéterminée dans un compteur/décompteur,
. cadencement du compteur/décompteur au moyen dudit signal électronique,
. détection d'un état dans lequel le compteur/décompteur présente une deuxième valeur prédéterminée, et
. nouveau pré-chargement de la première valeur prédéterminée dans le compteur/décompteur, procédé caractérisé en ce que les pré-chargements sont faits de manière asynchrone.

2. Procédé selon la revendication 1, dans lequel, le compteur/décompteur étant constitué de N bascules mémoire disposées en cascade, chacune destinée à être pré-chargée périodiquement, une bascule de rang i (pour i=2 à N) n'est pré-chargée qu'à la condition que la bascule de rang (i-1) ait été précédemment pré-chargée.

3. Diviseur de fréquence incluant N bascules mémoire, chacune munie d'une entrée d'horloge, d'une entrée d'autorisation de pré-chargement, et d'une sortie, la sortie d'une bascule de rang i (pour i=1 à N-1) étant reliée à l'entrée d'horloge de la bascule de rang (i+1), l'entrée d'horloge de la bascule mémoire de rang 1 étant destinée à recevoir un signal d'entrée du diviseur, la sortie de la bascule mémoire de rang N étant destinée à délivrer un signal de sortie du diviseur,
diviseur de fréquence caractérisé en ce qu'il est muni de moyens d'inhibition prohibant un pré-chargement simultané de toutes les bascules mémoire.

4. Diviseur de fréquence selon la revendication 3, dans lequel les moyens d'inhibition comprennent des moyens de retardement agencés de sorte qu'une bascule de rang i (pour i=2 à N) ne puisse recevoir d'autorisation de pré-chargement qu'à la condition que la bascule de rang (i-1) ait été précédemment pré-chargée.

5. Diviseur de fréquence selon la revendication 4, dans lequel les entrées d'autorisation de pré-chargement de deux bascules mémoire de rangs consécutifs sont reliées entre elles via une cellule à retard.

6. Boucle à verrouillage de phase comprenant :
. un premier oscillateur local destiné à délivrer un signal de sortie ayant une fréquence d'oscillation déterminée par la valeur d'une tension de réglage,
. un deuxième oscillateur local destiné à délivrer, via un diviseur de fréquence présentant un rapport de division programmable, un signal de référence ayant une fréquence de référence,
. un détecteur de phase/fréquence destiné à comparer la fréquence d'oscillation avec la fréquence de référence et à délivrer des signaux de commande représentatifs du résultat de ladite comparaison,
. une pompe de charge dont la conduction est destinée à être contrôlée par les signaux de commande, une sortie de la pompe de charge étant reliée à une capacité destinée à générer à ses bornes la tension de réglage,
boucle à verrouillage de phase caractérisée en ce que le diviseur de fréquence est conforme à la revendication 3, la programmation du rapport de division se faisant par un choix de valeurs de N bits d'un signal de sélection destinés à être périodiquement pré-chargés dans les N bascules mémoire.

7. Appareil récepteur de signaux radioélectriques, comportant un étage d'entrée permettant la réception d'un signal dont la fréquence est sélectionnée au sein d'une gamme de fréquences donnée, et sa transformation en un signal électronique dit signal radio, appareil dans lequel une conversion de fréquence, à partir de la fréquence sélectionnée vers une fréquence intermédiaire prédéterminée, est réalisée au moyen d'un mélangeur destiné à recevoir le signal radio, d'une part, et le signal de sortie d'un premier oscillateur local, appareil caractérisé en ce que la fréquence du signal de sortie du premier oscillateur local est régulée au moyen d'un boucle de verrouillage de phase conforme à la revendication 6.
